# EUROPEAN PATENT APPLICATION

(11) **EP 4 297 204 A1**
(43) Date of publication of application: **27.12.2023**
(21) Application number: 22180246.5
(22) Date of filing: 21.06.2022
(51) Int. Cl.: H01S 5/00

(54) **METHOD FOR MONITORING A PUMP LASER OF AT LEAST ONE OPTICAL AMPLIFIER IN AN OPTICAL TRANSMISSION LINK IN OPERATION**

(71) Applicant: ADVA Optical Networking SE, 98617 Meiningen (DE)
(72) Inventor: Rapp, Lutz, 73252 Lenningen (DE)
(74) Representative: Eder, Thomas

(57) **Abstract**

The present invention relates to a method for monitoring a pump laser (116) of at least one optical amplifier (100, 204) in an optical transmission link in operation, wherein the optical output power of the pump laser (116) to be monitored depends on an injection current and wherein the pump laser (116) to be monitored is operated at an operating point defined by a given value of the injection current and a corresponding value of the optical output power. The method comprises the steps of shifting the operating point of the pump laser (116) to be monitored to at least one shifted operating point, wherein the shifting is effected in such a way that the gain of the respective optical amplifier (100, 204) essentially reaches its steady state, determining information on the at least one shifted operating point, and using the information on the operating point and the at least one shifted operating point to determine information on the stage of aging of the pump laser (116) to be monitored.

## Description

The present invention relates to a method for monitoring a pump laser of at least one optical amplifier in an optical transmission link in operation, wherein the optical output power of the pump laser to be monitored depends on an injection current and wherein the pump laser to be monitored is operated at an operating point defined by a given value of the injection current and a corresponding value of the optical output power. The present invention furthermore relates to a control device for controlling and monitoring a pump laser of at least one optical amplifier in an optical transmission link, the control device being configured to receive information about an operating point of the pump laser to be monitored, wherein the operating point is defined by a value of the injection current supplied to the pump laser of the at least one optical amplifier and a corresponding value of the optical output power created by the at least one pump laser, and to output control information to the at least one optical amplifier at least comprising information defining the operating point. The present invention furthermore relates to an optical amplifier comprising a control unit configured for monitoring a pump laser of at least one optical amplifier in an optical transmission link in operation and to an optical transmission link comprising at least one such optical amplifier.

Long-haul optical transmission links that span hundreds or even thousands of kilometers, for example transatlantic optical transmission links, comprise optical amplifiers in order to optically amplify the one or more optical signals to be transmitted over the optical transmission links. These signals may include wanted optical transmission signals carrying user data as well as optical management signals. Generally, an optical amplifier comprises at least one pump laser, especially a semiconductor pump laser diode, creating an optical pump signal having an optical spectrum that does not overlap with the optical spectrum covered by the optical transmission signals to be amplified. The optical pump signal at a predetermined optical pump power as well as the optical signals to be amplified are coupled to an optical amplifier medium such as an erbium-doped optical fiber in which the signals to be amplified are amplified by stimulated emission. The gain of the optical amplifier depends on the optical pump power and the width of the optical spectrum occupied by the optical signals to be amplified. The optical pump power depends on the injection current supplied to the pump laser. The injection current, however, is limited and must not exceed a maximum value in order not to damage or even destroy the pump laser, especially due to an unacceptably high heat dissipation.

The pump lasers are the parts of the amplifiers, which are most affected by aging. As time progresses, a pump laser requires an increasing injection current in order to maintain a constant optical output power, i.e. a constant optical pump power. Once the aging effects become too strong, the pump lasers need to be replaced as the maximum value of the optical pump power that must be guaranteed according to the specification of the optical amplifier cannot be reached with an admissible injection current. It is thus necessary to monitor the pump lasers with respect to their aging status.

Many known monitoring techniques for pump lasers of optical amplifiers, especially erbium-doped fiber amplifiers (EDFA), allow monitoring of amplifier quality only at operating points at high values of the optical output power from the pump laser diodes (especially at or near a specified target value of the optical output power, see below). An operating point is defined by a given value of the injection current and a resulting value of the optical output power, i.e. the optical pump power provided by a pump laser. With these known methods it is, in particular, checked whether the currently required injection current that must be supplied to the pump laser diode in order to create the specified target value of the optical output power exceeds a beginning-of-life (BOL) injection current that is required to create the target value of the optical output power by a certain percentage. This target value of the optical output power is chosen in such a way that it can be maintained for (at least) a given operating time during which the injection current must be increased due to aging effects in order to maintain the target value of the optical output power without exceeding a maximum (threshold) value of the injection current. Typically, the target value of the optical output power of a pump laser is specified in such a way that the injection current can be increased by up to 10% as compared with the BOL injection current until the maximum admissible (threshold) injection current is reached.

This technique comes with severe drawbacks and is in many cases not able to detect degradation of the pump laser diodes, as it is only capable of producing reliable results in cases in which the pump laser to be monitored is operated at or near the specified target value of the optical output power. However, pump lasers of optical amplifiers are often operated at a much lower optical pump power and thus at an injection current that is significantly smaller than the BOL injection current. In consequence, no alarm would be triggered although system operation, i.e. the whole transmission link, could fail if it becomes necessary to operate the respective optical amplifier (that includes the degraded pump laser) at the target optical output power. This would, for example, be the case if a wavelength division multiplex (WDM) transmission link that has been specified for a given maximum number of optical transmission channels and is currently operated with a lower number of optical transmission channels shall be upgraded to a higher, especially the maximum number of optical transmission channels. Using this known standard technique, it is, for example, impossible to acquire reliable information on whether it is still possible to expand the optical WDM transmission link to the given maximum number of channels without increasing the injection current beyond the maximum admissible injection current (e.g. 10% higher than the BOL current).

The dependency of the output power of a pump laser diode on the injection current is typically characterized by the so-called LI curve with a clear threshold behavior. This means, at low values of the injection current the optical output power rises very slowly. If the value of the injection current exceeds a threshold value, the LI curve becomes significantly steeper (almost linear) with a gradient depending on the stage of aging. If operated below the current threshold, the laser diode emits essentially incoherent light (like a light-emitting diode (LED)), whereas lasing (creation of coherent light) is achieved above the threshold.

A simple enhancement of the standard monitoring technique described above that allows monitoring of the aging status at power levels smaller than the maximum BOL output power is based on the assumption that the pump power is proportional to the injection current (DE 10 2007 019 345 B4). This method, however, neglects the impact of the threshold current, i.e. the actual course of the LI curve. Taking into account that the threshold current may amount to almost 10% of the BOL current, it becomes clear that this technique can provide usable results only if the output power of the operating point that is used to determine the slope of the proportional approximation of the actual LI curve is close to the specified target output power. It shall be mentioned at this point that the terms "optical power" and "injection current", where applicable, are, as a short form, also used in order to designate respective values of these parameters.

A solution to overcome this problem would be to record the complete LI curve of the pump laser during manufacturing of the optical amplifier or during its first installation in a transmission system. With this known (BOL) LI curve it would be possible to compare the current injection current that is required to create a given optical pump power with the corresponding injection current providing the same optical output power at BOL conditions. However, this method increases production or installation time. Furthermore, amplifiers already installed in the field cannot be easily upgraded with this monitoring method as this would make it necessary to interrupt the transmission link and, as the case may be, to have physical access to the optical amplifiers in order to carry out the measurements and/or to install a new soft- or firmware.

Another approach for monitoring the quality of an amplifier in operation is described in Lutz Rapp, "Quality Surveillance Algorithm for Erbium-Doped Fiber Amplifiers", Proc. DRCN, 2005 (corresponding patent: US 7.379,234). This method allows to monitor the complete optical path within the amplifier and is - in contrast to the other techniques - not limited to monitoring the aging of the pump lasers. Furthermore, aging effects can be detected for arbitrary channel loads and power distributions at the input of the optical amplifier. However, the implementation of this method in an optical amplifier is complex and additional calibration data is required. Therefore, this method is not suitable for upgrading monitoring capabilities of an amplifier that is already installed in the field without interruption of the transmission link.

A monitoring method using high frequency modulation of the injection current for determining the slope of the LI curve is described in US 7,038,769 B2. The modulation frequency must be higher than the cut-off frequency of the optical amplifier in order to avoid channel distortions. In this context, the term "cut-off frequency" means the frequency of the modulation component of the injection current above which the optical gain of the optical amplifier (created within the optically pumped medium, e.g. the erbium-doped optical fiber) shows a sufficiently reduced modulation component (e.g. defined by a quotient of the amplitude of the optical gain at the given modulation frequency and the amplitude obtained with the same amplitude of the modulation component of the injection current at a very low frequency, e.g. a few Hertz, wherein the cut-off frequency may be defined as the frequency as of which this quotient is lower than a given value, e.g. 0.5). In this publication, a modulation frequency of 2 MHz is proposed. This method, however, requires additional hardware components and is therefore not suitable for upgrading amplifiers that are already installed in the field. Furthermore, this method limits the maximum usable optical pump power.

Starting from this known prior art, it is an object of the present invention to provide a method for monitoring a pump laser of at least one optical amplifier in an optical transmission link in operation that can be carried out during operation of the optical amplifier, that does not require additional hardware or modification of the hardware, and that can easily be implemented in existing optical amplifiers, even during operation. It is a further object of the invention to provide a control device for controlling and monitoring a pump laser of at least one optical amplifier in an optical transmission link in operation that is configured to implement this method. It is a further object of the invention to provide an optical amplifier comprising such a control unit and an optical transmission link comprising at least one optical amplifier and such a control unit.

The present invention achieves these objects with the combinations of features of claims 1, 10, 12 and 13, respectively.

The invention starts from the finding that the extent of aging at any arbitrary operating point can be determined by shifting the operating point of the pump laser to be monitored for a predetermined time interval to at least one further shifted operating point, and by using the information on the operating point and the at least one further shifted operating point in order to determine information on the stage of aging of the pump laser to be monitored, especially by using a mathematical regression method, i.e. by determining the current course of the LI curve from the measured operating points. According to the invention, shifting to the at least one further operating point is effected in such a way that the gain of the respective optical amplifier essentially reaches its steady state. That is, the change may either be effected by keeping the injection current and the pump power defining a given operating point constant until the optical gain reaches its steady state or by continuously changing the operating point (e.g. by slowly modulating the injection current) at a modulation frequency that is at least lower than the cut-off frequency of the optical amplifier, which is mainly determined by the characteristic of the optically pumped medium (e.g. an erbium-doped fiber).

As the driver components of pump lasers are in general designed in such a way that only slow changes of the injection current are possible, the method according to the invention allows accurate monitoring of the aging of pump lasers over a wide range of output powers and therefore at a large variety of operating conditions, without requiring any modification of the hardware or additional calibration data. It allows to upgrade optical amplifiers installed in the field via a simple software change. The respective software may be part of a control device that is included in the respective amplifier, i.e., the software change may be effected by uploading an upgraded software or an additional software module to the control device. The software may also be part of a higher instance control device (e.g., a management system that controls a whole transmission link including all optical amplifiers comprised by the transmission link).

According to an embodiment of the invention, the at least one shifted operating point can be created by controlling the injection current to a different, shifted value and the resulting optical power can be measured to obtain the full information on the shifted operating point. Alternatively, the at least one shifted operating point can be created by controlling the optical pump power to a different, shifted value and measuring the resulting injection current in order to obtain the information on the shifted operating point. As many optical amplifiers comprise a control device that is capable of controlling the optical power of a optical transmission signal at an output port of the optical amplifier to a predetermined value, it is also possible to control this optical power to a different, shifted value and to measure the resulting optical pump power and the resulting injection current to obtain the information on the shifted operating point.

The at least one shifted operating point can be determined in such a way that one or more parameters characterizing the transmission quality of the optical transmission link are not changed by more than a predetermined amount or do not exceed a predetermined threshold or do not fall below a predetermined threshold. This ensures that the live traffic over the optical transmission link is not interrupted while the amplifier is being monitored. As a relevant parameter, e.g., the bit error rate determined at the respective downstream end (with respect of the transmission direction comprising the optical amplifier(s)) of the transmission link may be used. It is also possible to set a maximum drop of the gain of the optical amplifier including the pump laser to be monitored and to allow only changes (especially reductions) of the optical pump power that create a corresponding acceptable change of the gain (or the optical output power of the optical transmission signal at the output port of the optical amplifier).

According to a further embodiment, the change in optical output power of a first pump laser between the operating point and the at least one further operating point can be compensated by a change of an injection current of at least one second pump laser.

In such embodiments, the second pump laser may be a component of the same optical amplifier as the first pump laser. In such a case, for example, if the first and second pump lasers are included in a two-stage amplifier, which comprises two pump lasers, monitoring can be carried out without changing the total gain of the optical amplifier. The injection current of the first pump laser can be reduced or increased which creates a reduction of or an increase in the pump power (and thus of the optical gain of the first amplifier stage), while the injection current of the second pump laser can be increased or reduced, which leads to an increase in or reduction of the optical pump power (and thus of the optical gain of the second amplifier stage), in order to compensate the shift of the operating point of the first pump laser. It is, of course, also possible that the compensation is not fully effected by a single second pump laser but by two or even more second pump lasers. A control device included in the optical amplifier that comprises the at least two stages (each of which comprises the first or a second pump laser) may be configured to carry out the monitoring method without creating additional traffic, e.g., in a management channel.

Alternatively, in such embodiments, the second pump laser may be a component of a further optical amplifier. This, however, leads to a change of the optical power of the optical transmission signal carrying used data between the respective two optical amplifiers that include the first and second optical amplifier, respectively. Further, this embodiment requires transmission of control or management information from and/or to the optical amplifiers comprising the respective first and (one or more) second pump lasers.

According to a further embodiment, the compensation of the variation of the optical power may be attained by measuring the optical power of an optical transmission signal at a predetermined position within the optical transmission link, which is located downstream of the at least one second pump laser, preferably in the region of an output port of a selected optical amplifier. This measured signal can be used as a target signal when controlling the pump power of the at least one second pump laser. Especially, the at least one second pump laser can be controlled in such a way that the optical power of the signal remains essentially constant. In this way, using the optical power of the signal at the respective position within the optical transmission link may be used to carry out the monitoring method according to the invention including compensation for all first and second pump lasers positioned upstream of the measurement position.

According to another embodiment, the information on the stage of aging of the pump laser to be monitored comprises a maximum value of the optical output power at a predetermined maximum value of the laser injection current of the amplifier in its current stage of aging or an information dependent on this maximum value of the optical pump power. This maximum optical pump power that is determined using the at least two operating points (i.e., the respective two pairs of injection current and optical pump power values) by applying a mathematical regression method, e.g., linear regression, cannot be exceeded. If, for example, an optical WDM transmission system shall be expanded by one or more optical (WDM) transmission channels, the pump power of the pump lasers of all optical amplifiers must be increased by a predetermined amount. This information may be provided or determined by a management or control device as known in the prior art. Further, each optical amplifier may provide information to the management or control device including the maximum optical pump power that can be created by each pump laser. From this information, the management or control device may, in advance, determine whether the intended increase in transmission channels is possible. In this way, it is, for example, possible to examine whether a transmission link currently still fulfills its specification requirements, e.g., its capability of transmitting a given number of optical WDM transmission channels.

Alternatively, the information on the stage of aging of the pump laser to be monitored can be a maximum number of channels by which the optical WDM transmission link can be expanded without exceeding a given maximum value of the injection current.

This information, provided by each optical amplifier (for each of the pump lasers included therein) may be provided to a higher-level management system or device which may then determine the maximum number of channels that can be used for transmission by the whole transmission link (even if this number is smaller than the specification requirement).

According to another embodiment, the information on the stage of aging can be obtained at predetermined points in time or at given time intervals. From this information, the maximum period of time may be determined for which the pump laser that is monitored or the optical amplifier including this pump laser fulfills a predetermined specification requirement (e.g., a predetermined minimum value of the pump power that is reached at the maximum admissible value of the injection current). Of course, instead of the remaining time interval, the absolute point in time may be determined at which the pump laser monitored (or the optical amplifier) will (likely) fail.

The control device according to the invention is configured to carry out the invention according to the invention described above. It may be included in an optical amplifier, especially if the amplifier is a two or n-stage optical amplifier. Such a control device may be configured to monitor one or all of the pump lasers included in the respective amplifier. The control device may, however, also be provided as a separate control device that is configured either to monitor the pump lasers of a single or more dedicated optical amplifiers or even all optical amplifiers provided in an optical transmission link. The control device may be provided at an end of the optical transmission link. In this case, information between the control device and one or more optical amplifiers may be exchanged via a management channel that can be realized in any known manner, e.g., by amplitude-modulating a single optical transmission signal at a maximum modulation frequency that is at least one order (i.e., at least the factor 10) lower than the bit rate or minimum modulation frequency of the optical transmission signal. In case of an optical WDM signal, it is also possible to (correspondingly slowly) modulate the optical WDM signal. Of course, in this case, each optical amplifier must comprise a transceiver configured to bidirectionally communicate with the control device.

Further embodiments of the invention are apparent from the dependent claims.

In the following, the invention will be described in more detail with reference to the drawings. In the drawings,
- Fig. 1: shows a diagram illustrating the dependency of the optical output power of a pump laser on the injection current (i.e., the LI curve) at beginning-of-life (BOL) and after aging;
- Fig. 2: shows a diagram showing the LI curve of Fig. 1 explaining the effect of a channel upgrade;
- Fig. 3: shows a diagram, visualizing determination of shifted operating points;
- Fig. 4: shows the schematic structure of a two-stage optical amplifier realized as a two-stage EDFA;
- Fig. 5: shows a control device controlling a two-stage optical amplifier;
- Fig. 6: shows a diagram illustrating the compensation of a first pump laser by a second pump laser in a two-stage optical amplifier as shown in Fig. 4;
- Fig. 7: shows an optical transmission link comprising a control device;
- Fig. 8: shows a diagram illustrating the relationship between the optical output power and the noise figure;
- Fig. 9a: shows a diagram indicating the allowable pump power variation of pump 1 over output power of the optical transmission signal carrying user data while keeping the noise figure degradation smaller than 1 dB.
- Fig. 9b: shows a diagram indicating the allowable pump power variation of pump 2 over output power of the optical transmission signal carrying user data while keeping the noise figure degradation smaller than 1 dB.

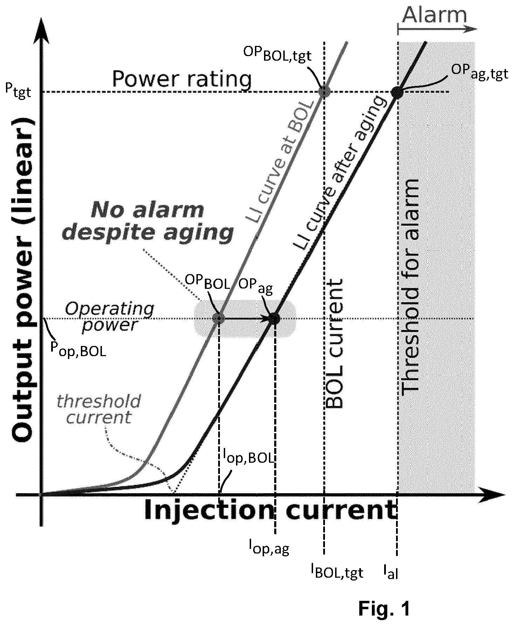

Fig. 1 shows a diagram illustrating the dependency of the optical output power (i.e. the optical pump power) of a pump laser realized as semiconductor laser diode on the injection current (i.e., the LI curve) at beginning-of-life (BOL) and after aging with the injection current on the horizontal axis and the output power on the vertical axis. The two curves shown are the LI curve at beginning-of-life and the LI curve after aging for a given time. As already mentioned, the characteristic course of a laser LI curve shows two almost linear sections: In a first rather flat section, in which the value of the injection current is between zero and a threshold value, no lasing takes place and the pump laser creates incoherent light as an LED. In a second much steeper section, in which the value of the injection current is between the threshold value and the maximum admissible threshold value designated as Iₐₗ, lasing takes place and the pump laser creates (coherent) pump light. The maximum threshold value Iₐₗ of the injection current must not be permanently exceeded in order not to damage or even destroy the pump laser. In many cases, the electrical drives are even not able to provide significantly higher injection currents.

The area on the right of the coordinate system defined by injection currents larger than the value Iₐₗ represents an "alarm-area". If, during monitoring of the pump laser, the current value of the injection current exceeds this maximum value Iₐₗ, an alarm is created. Furthermore, an alarm is created if it is found, during monitoring the pump laser when operated at an operating point having an injection current value lower than the value Iₐₗ, that the value Iₐₗ would be exceeded if the operating point was shifted to a specified target value P_{tgt} of the optical pump power.

The target value P_{tgt} of the optical output power of the pump may, for example, be required in order to obtain a correspondingly high gain of an optical amplifier comprising the pump laser, wherein the gain is defined as the ratio of the optical power of the output signal amplified by the optical amplifier and the optical power of the optical input signal supplied to the optical amplifier. As already mentioned above, in an optical WDM transmission link, the pump power must be the higher the more optical channel signals are to be optically amplified in order to reach a given (minimum) gain for each of the optical channel signals. That is, the optical amplifiers in optical WDM transmission links must be specified in such a way that a predetermined gain can be reached for each transmission channel even if the maximum specified number of optical channels is used for transmitting a respective maximum number of optical channel signals.

Fig. 1 shows two operating points OP_{BOL,tgt} and OP_{ag,tgt} at the target value P_{tgt} of the optical output power on the LI curve at BOL and the LI curve after aging. Apparently, the injection current must be increased from the value I_{BOL,tgt} to the maximum admissible value Iₐₗ in order to compensate the aging effect and to maintain the target value P_{tgt} of the optical pump power. If further aging of the pump laser were to take place, the specified target value P_{tgt} of the optical pump power would no longer be reached at an admissible value of the injection current, i.e., at a value lower than Iₐₗ.

As apparent from the LI curve for the aged pump laser in Fig. 1, the maximum admissible aging status of the pump laser that is characterized by the LI curve after aging is the border-line status in which the pump laser is able to match the specification requirement, namely, to create the optical pump power P_{tgt} at an injection current Iₐₗ that can just be permanently maintained.

Fig. 1 further shows, as an example, two possible operating points OP_{BOL} and OP_{ag} at a value of the optical pump power of P_{op,BOL} in a middle range of the LI curve at BOL and after aging, respectively. In practice, an optical amplifier might be operated at such operating points if not the specified target value of the optical pump power P_{tgt} is required in order to obtain a desired gain of the respective optical amplifier. As apparent from the LI curves in Fig. 1, the injection current must be increased from a BOL value of I_{OP,BOL} to a value of I_{op,ag} in order to maintain the optical pump power value of P_{op,BOL} after aging, i.e., in order to adjust the corresponding operating point OP_{ag} on the LI curve for the aged pump laser.

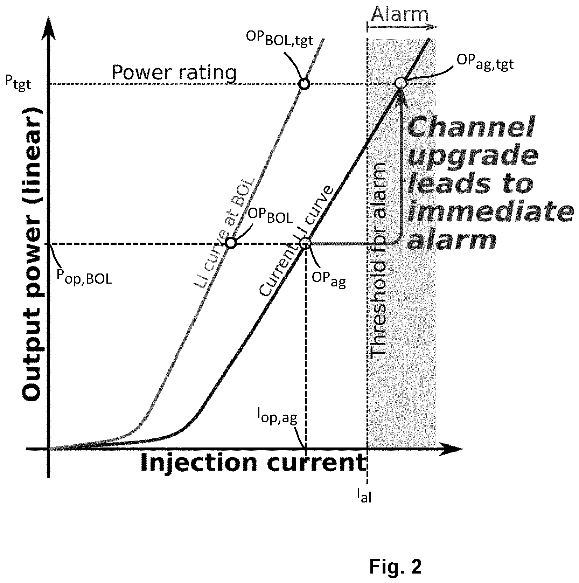

Fig. 2 shows essentially the same diagram as Fig. 1. However, the aging process of the pump laser has progressed further. As apparent from the LI curve for the aged status, it is not possible any more to reach the target value P_{tgt} of the optical pump power with an injection current below the maximum threshold value Iₐₗ. A shift of the operating point OP_{ag} having values I_{op,ag} and P_{op,BOL} to an operating point OP_{ag,tgt} at the optical pump power value P_{tgt} would lead to an inadmissibly high injection current beyond the maximum threshold current Iₐₗ. Thus, the pump laser should be replaced before a situation occurs in which the target optical pump power P_{tgt} is required, e.g., as mentioned in Fig. 2, in case of a channel upgrade in an optical WDM transmission link.

This highlights the need for a monitoring method which makes it possible to assess whether the pump laser still matches its specification requirements in its current aging status. It would also be desirable to determine the remaining operational life span of a pump laser in an optical amplifier.

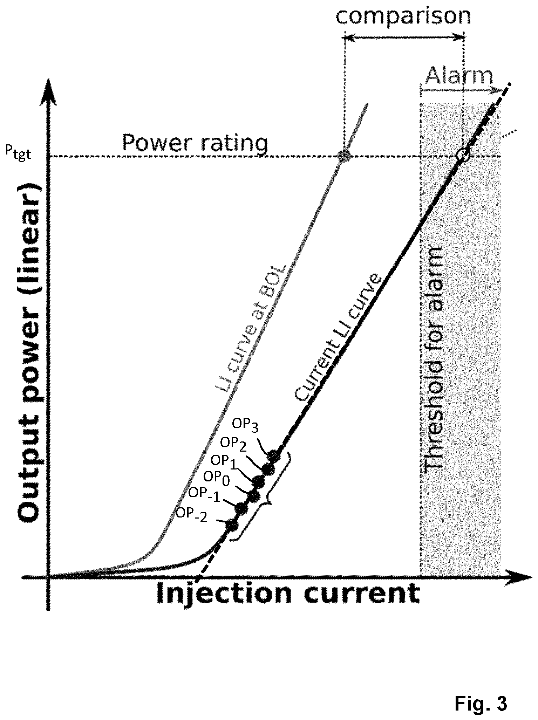

Fig. 3 shows essentially the same diagram as Fig. 2. As is the case for the LI curve after aging in Fig. 2, the current LI curve after aging has such a low slope (in the section beyond the threshold at which lasing occurs) that the specified target value of the optical pump power cannot be reached with an injection current lower than the maximum threshold value Iₐₗ, that is, for example, a channel upgrade to a given maximum number of channels in an optical WDM transmission link would not be possible or, if carried out, would trigger an alarm.

In Fig. 3, a plurality of possible operating points OP₀, OP₁, OP₂, OP₃, OP-₁, OP-₂, are shown on the LI curve after aging. The operating point OP₀ may be an initial operating point that is maintained throughout a normal operation mode of an optical amplifier comprising the pump laser to be monitored. The operating points OP₁, OP₂, OP₃ reveal increasing values of the injection current and thus of the optical pump power, whereas operating points OP-₁, OP-₂ reveal decreasing values of the injection current and thus of the optical pump power.

According to the invention, the course of the current LI curve (i.e., the course of the LI curve characterizing the pump laser in its current stage of aging) can be determined by shifting the pump laser from an initial operating point to at least two, preferably more than two, operating points (in the current stage of aging) and determining the respective values of the injection current and the optical pump power. Using these values, any suitable mathematical regression method can be used in order to reconstruct or approximate the actual course of the current LI curve by an analytical function. Especially linear regression may be used in order to approximate the actual LI curve. The corresponding analytical (or numerically described) function can then be used to determine the values defining any other operating point. For example, as explained above, this function may be used to determine whether an operating point at the specified target value P_{tgt} of the optical pump power can (still) be reached with an injection current below or at the maximum threshold value Iₐₗ.

It is further possible to determine a remaining time span for the pump laser monitored in which the pump laser is able to create the specified target pump power P_{tgt} with an admissible value of the injection current that is lower than Iₐₗ. For this, the method explained above can be carried out from time to time (at predetermined points in time, e.g., at equidistant points in time), wherein the injection current I_{tgt} is determined that is necessary to create the target pump power P_{tgt}. From these pairs of values, each comprising the respective point in time and the respective value I_{tgt} of the injection current, an aging function may be determined, e.g., using a mathematical regression method, especially linear regression. The aging function I_{tgt}(time) may be used to calculate the point in time at which the injection current I_{tgt} reaches the maximum admissible value Iₐₗ. In this way, the life-time of a pump laser may be assessed and the pump laser may be replaced in good time before its aging status reaches progresses beyond the border as of which the pump laser cannot match its specification requirements any more. Furthermore, quality of the pump laser can be indicated by relating the aging that has already happened to the maximum allowed aging, wherein aging is expressed in terms of the injection current I_{tgt} that is necessary to create the target pump power P_{tgt}

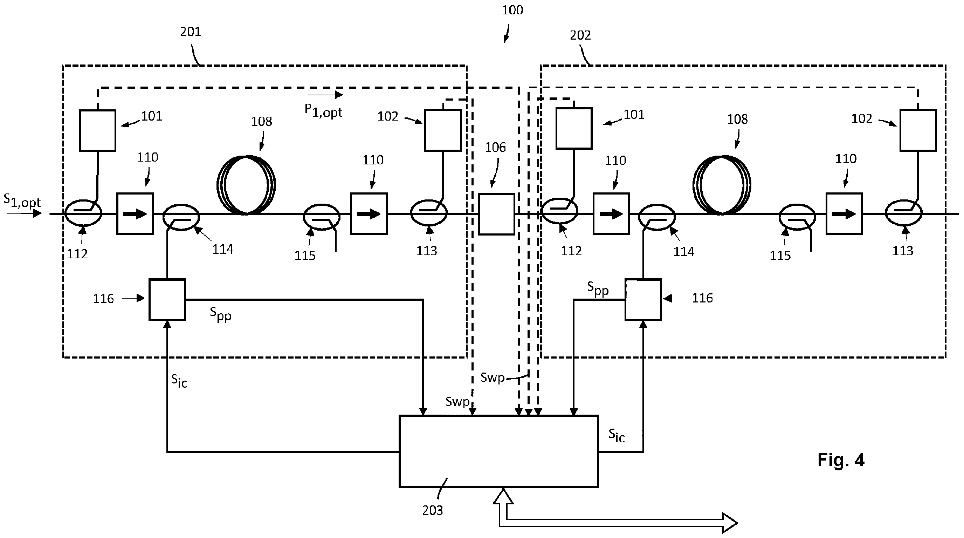

Fig. 4 shows the schematic structure of a two-stage optical amplifier realized as a two-stage EDFA. The function of a two-stage EDFA is considered to be common knowledge of a skilled person, it will therefore only briefly be explained here. The amplifier comprises two stages 201 and 202, which are connected by a variable optical attenuator (VOA) 106. An optical transmission signal S_{1,opt} is fed to an input port of the first stage of the EDFA as shown on the left side of Fig. 4. First, using a first tap coupler 112, which is configured to tap off a small portion of the optical power of the optical transmission signal S_{1,opt}, the optical power of the incoming optical transmission signal S_{1,opt} (i.e. its absolute value or a (relative) value corresponding thereto) is measured by a first optical sensor device 101 comprising a monitor photo diode. The information about the optical power of the optical transmission signal S_{1,opt} measured by the first sensor device may be fed to a control device 203 as indicated by the dashed arrow.

Next, the optical transmission signal passes through an optical isolator 110, which blocks reflected signal components and pump power components as well as backward propagating light consisting of ASE (Amplified Spontaneous Emission) created in the optically pumped media of the EDFA, In the further course of the optical signal path through the optical amplifier 100, a high-power pump light, created by a pump laser 116, is combined with the incoming optical transmission signal S_{1,opt} using a first wavelength selective optical coupler (WSC) 114. The optical transmission signal S_{1,opt} and the pump light reveal non-overlapping optical spectra. The combined light is then guided into a pump section realized by an erbium-doped fiber (EDF) 108. The optical pump light created by the pump laser excites the erbium ions to a higher-energy state. The photons of the optical transmission signal S_{1,opt} at wavelengths differing from the wavelength of the pump light interact with the excited state of the erbium ions, wherein erbium ions are caused to drop from the excited state to a lower-energy state. In this way, additional photons are created having exactly the same wavelength, phase and direction as the photons of the optical transmission signal S_{1,opt} to be amplified. The whole additional signal power is guided in the same fiber mode as the incoming optical transmission signal S_{1,opt}.

The remaining portion of the pump light that has not been used in order to create the stimulated light is extracted from the main optical path through the optical amplifier 100 using a second (optional) WSC 115. The optical transmission signal S_{1,opt} remaining within the optical path passes through a second optical isolator 110. In a next step, using a second tap coupler 112, the optical power (i.e., its absolute value or a (relative) value corresponding thereto) of the incoming optical transmission signal S_{1,opt} is measured by a second optical sensor device comprising photo diode 102. The information about the amplified optical power of the optical transmission signal S_{1,opt} may be transmitted to the control device 203 as indicated by the dashed arrow. The amplified optical signal S_{1,opt} is output at an output port of the first stage 201 of the two-stage optical amplifier 100.

The optical transmission signal S_{1,opt} that has been amplified by the first stage 201 passes through the VOA 106, which connects the two stages of the optical amplifier, and is then fed to an input port of the second stage 202 of the optical amplifier 100. The VOA 106 may be configured to level the gain of the optical amplifier 100 at differing signal wavelengths in order to achieve gain flatness, i.e., the VOA may be configured as a gain equalization filter. Alternatively, gain flattening may be achieved by a passive filter incorporated in the setup and called gain-flattening filter (GFF).

The second stage 202 of the two-stage optical amplifier 100 reveals the same structure as the first stage 201. Thus, corresponding components are designated by identical reference numbers. Also, the general functionality of the components of the second stage 202 is essentially identical to the functionality of the first stage 201.

As shown in Fig. 4, the control device 203 may be implemented as a unit comprised by the optical amplifier 100. However, in other embodiments, the control device 203 may be realized separate from the optical amplifier 100 and positioned near the optical amplifier 100 or even at a different location. In the latter embodiment, control signals and/or information exchanged between the control unit 203 and the pump laser 116 to be monitored and/or between the control unit 203 and other components of the optical amplifier 100, especially information created by the sensor devices 101, 102, can be transmitted by means of a management channel of the optical transmission link. In this case, the optical amplifier 100 must comprise an optical transceiver device which is configured to transmit information from the optical amplifier 100 to the control device 203 and to receive information from the control device 203. Of course, further components might be comprised within the optical amplifier 100 which convert the information received into corresponding control signals that are supplied to respective components of the optical amplifier 100, especially to the pump lasers 116. Likewise, further components might be comprised within the optical amplifier 100 which receive information created by other components, especially the pump lasers 116 and the optical sensor devices 101, 102 and which, as the case may be, convert this information into information that can be transmitted to the control device 203 by the respective optical transceiver device.

Even in an embodiment in which the control device 203 is comprised by the optical amplifier 100 or is located, as an external device, near the optical amplifier 100, further information may be exchanged between the control device 203 and a higher order management device or system which may be configured to control the whole optical transmission link comprising the optical amplifier 100 or even a plurality of optical transmission links. Also, for this purpose, a management channel may be used as explained above.

As explained above, the method for monitoring a pump laser according to the invention can be carried out during normal operation of the optical transmission link. It shall be assumed that the respective optical transmission link (not shown) is operated, during its normal operation, in such a way that the pump laser 116 of the optical amplifier 100 to be monitored is operated at an operating point OP₀ shown in Fig. 3. This operating point P₀ may in many cases differ from the operating point at the target value P_{tgt} of the optical pump power (and the corresponding injection current).

However, as already explained above, in order to assess whether the respective pump laser 116 is still able to be operated at an operating point at the target value P_{tgt} of the optical pump power, it is necessary to gain sufficient information about the LI curve that characterizes the current status of the pump laser 116. For this purpose, the pump laser 116 to be monitored is operated at at least two different operating points. Using the pairs of values (in the LI curve) of the at least two operating points, the course of the LI curve in the current status of the pump laser 116 can be assessed by using a mathematical regression analysis.

In order to control the operating point of the pump laser 116 to be monitored, the control device 203 creates an interaction current control signal S_{ic}, which is fed to the respective pump laser 116 or the respective driver circuit. In this way, the control device may shift the operating point to at least one further operating point, e.g., one of the operating points OP₋₂, OP₋₁ at a lower optical pump power or OP₁, OP₂, OP₃ at a higher pump power (relative to the optical pump power of the operating point OP₀) shown in Fig.3. As explained above, this shift is effected in such a way that the gain of the respective optical amplifier or amplifier stage essentially reaches its steady state, which is usually essentially determined by the characteristics of the optical pump media, e.g., the EDF. Especially, the shift may be effected in such a way that the operating point of the respective pump laser 116 remains constant for a specified time interval that is long enough for the optical output power of the (amplified) optical signal at the output port of the optical amplifier 100 or the respective amplifier stage 201, 202 to reach a constant value. In order to check whether this steady-state condition for the optical amplifier (or the respective states) has been reached, the control device 203 may evaluate a signal S_{wp} created by the second optical sensor device 102 as this signal is a measure for the optical power of the amplified signal S_{1,opf}.

In one embodiment, one or more shifted operating points OPᵢ (e.g., the operating points OPᵢ (-2 ≤ i ≤ 3, i≠0 ) as shown in Fig. 3) are adjusted by controlling the injection current to a different, shifted (fixed) value. In this case, the control device 203 outputs control information to the optical amplifier 100 in the form of the interaction current control signal S_{ic} comprising information on the desired value of the injection current, which is to be supplied to the pump laser 116. As a reaction, the pump laser creates the pump light at a pump power according to the current LI curve. This pump power is measured by the pump laser 116, e.g., with the aid of the monitor diode and, as the case may be, an appropriate electrical amplifier. The respective information is included in a pump power signal Sₚₚ created by the pump laser 116. This signal is fed to the control device 203, which has thus knowledge of the respective pairs of values of operating points. Using this information, the control device is capable of carrying out any further step of the method according to the invention, especially carrying out a regression analysis, and of determining the values of any operating point on the current LI curve. In a further step, this information can be used to assess whether the pump laser 116 is still capable of matching its specification requirements, especially, whether the pump laser 116 is capable of being operated an operating point at the target value of the optical pump power P_{tgt} without exceeding the maximum possible value of the interaction current Iₐₗ.

In another embodiment, one or more shifted operating points OPᵢ may be adjusted by controlling the optical pump power to a different, shifted value. In this case, the control device 203 outputs control information to the optical amplifier 100 comprising information about the desired optical output power. In this case, an already existing feedback control loop, implemented in the control device 203, may be used.

In a further embodiment, one or more shifted operating points OPᵢ may be adjusted by controlling the optical power of an optical transmission signal at the output port of the optical amplifier 100 or, preferably, at the output port of the respective stage 201, 202 of the optical amplifier 100 comprising the pump laser 116 to be monitored to a different, shifted value. For this purpose, a feedback control loop might be used, which is usually present in an optical amplifier, wherein the feedback control loop may be implemented by the control device 203. In this case, the control device 203 adjusts the interaction current by monitoring the corresponding signal S_{wp} of the second optical sensor device and creating and feeding an appropriate injection current control signal S_{ic} to the respective pump laser 116 to be monitored.

As, in the simplest embodiment, shifting of the operating point (by statically adjusting one or more shifted operating points OPᵢ or dynamically (slowly enough) shifting the operating point and measuring respective pairs of values of the current LI curve) is carried out so slowly that the gain of the optical amplifier (i.e., at least of the stage of the optical amplifier that includes the pump laser to be monitored if the amplifier comprises more than one stage) is correspondingly varied, a maximum shift as compared to the normal operating point during the current normal operation of the optical transmission link should not be exceeded. This maximum shift should be determined in such a way that the optical transmission link is still capable of receiving the amplified optical transmission signal S_{1,opf} correctly, i.e., with a sufficient quality at the respective end of the optical transmission link.

In order to guarantee a sufficient transmission quality, one or more parameters characterizing the transmission quality of the optical transmission link can be monitored when carrying out the monitoring method for one or more pump lasers in one or more optical amplifiers. Likewise, it is also possible to determine a maximum shift of an operating point in advance so that it is not necessary to monitor the transmission quality of the optical transmission link while carrying out the monitoring method for the pump laser(s). In both cases, the one or more parameters characterizing the transmission quality should not be changed by more than a predetermined acceptable amount or should not exceed or not fall below a predetermined threshold, respectively.

The one or more parameters characterizing the transmission quality may comprise the optical power of the optical transmission signal S_{1,opf} at an output port of the optical amplifier 100 including the pump laser to be monitored (or at any position within the transmission link downstream the point at which the pump power of the pump laser to be monitored is coupled to the transmission path) or the bit error rate (BER) at the end of the optical transmission link. According to a further alternative, the error vector magnitude (EVM) may be used as a parameter that characterizes the transmission quality. The optical power of the optical transmission signal carrying user data should not fall below a threshold value while the BER or EVM should not exceed a predetermined threshold in order to ensure a sufficient transmission quality. Especially, if the acceptable range of the shift of the operating point is low, the value pairs of more than two, preferably a plurality of at least five, most preferably a plurality of at least ten at least slightly shifted operating points should be determined in order to reach a sufficiently high approximation of the current LI curve by means of the regression analysis.

As explained above, the (values of the) one or more parameters characterizing the transmission quality may be supplied to the control device 203 via a management channel in case the control device 203 monitors whether the values of these parameters remain in an acceptable range (or whether given thresholds are exceeded).

As explained above, the calculations and application of the regression method may be carried out by the control device 203. It is, however, also possible to transmit the values defining the two or more operating points to a further device, e.g., a higher order management device or system, which is configured to carry out the calculations required and any process necessary in order to assess aging characteristics of the pump laser to be monitored.

As a simple example, in Fig. 3 the actual current LI curve characterizing the aged status of the pump laser, more particularly, the almost linear lasing section of the LI curve (at injection current values larger than the lasing threshold), has been approximated by a straight dashed line which has been obtained by a linear regression method using the operating points OPi (-2 ≤ i ≤ 3). As apparent from Fig. 3, the respective approximation is sufficiently accurate in order to predict that the pump laser, in its current stage of aging, no longer fulfills its specification requirements as an increase inthe output power at the operating point P₀ (i.e. the operating point in the current "normal" operation of the optical amplifier) to the target value of the output power P_{tgt} would require an injection current greater than the maximum value Iₐₗ, which would trigger an alarm.

It is, of course, also possible to acquire, as information on the stage of aging of the pump laser to be monitored, a maximum value of the optical output or pump power at the predetermined maximum value of the laser injection current Iₐₗ in its current stage of aging or information dependent on this maximum value of the optical output power.

In another embodiment, the optical transmission link is an optical WDM transmission link which, in the current operating mode, is operated with a number of optical channels smaller than a specified maximum number of channels. The information on the stage of aging of the pump laser to be monitored 116 may be the maximum number of channels or the maximum capacity by which the optical WDM transmission link can be expanded without exceeding a given maximum value of the injection current of the respective optical amplifier 100. Optionally, the information on the stage of aging of the pump laser 116 to be monitored comprises the information whether it is still possible to expand the optical WDM transmission link to the given maximum number of channels without exceeding a given maximum value of the injection current.

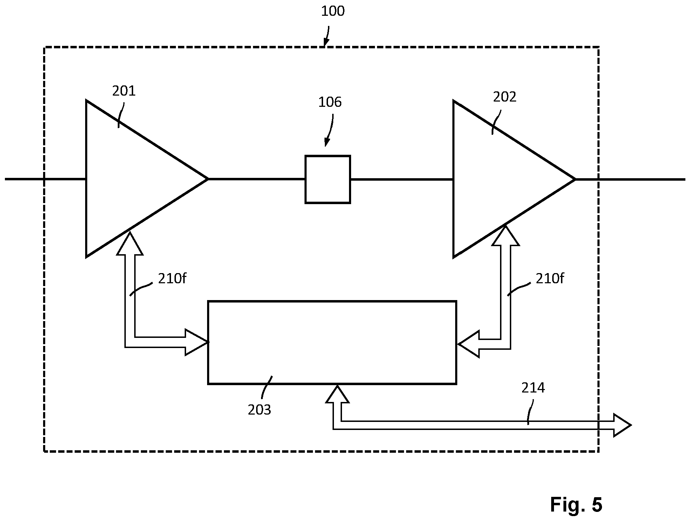

Fig. 5 illustrates a simplified block diagram of the two-stage optical amplifier 100 in Fig. 3. The two stages 201, 202 are separated by the VOA 106. Bidirectional communication paths 210 and 214 for transferring information between the control device 203 and the amplifier stages 201, 202 and a higher order management device or system are indicated by respective double arrows. In the embodiment of the optical amplifier 100 shown in Fig. 5, the control device 203 is comprised by the optical amplifier 100. However, as mentioned above, the control device 203 may also be provided as an external component, even at a different location. A higher order control device may also be configured to control and communicate with two or more optical amplifiers (i.e., with a lower order control device that is included in the optical amplifier or provided as a separate device at the respective location of the optical amplifier) and to fully or partially carry out the monitoring method for two or more pump lasers.

In the embodiments shown in Figs. 4 and 5, the change in optical output power of the first pump laser 116 in one of the stages 201, 202 between the operating point and the at least one further operating point may be compensated by a change of an injection current of at least one second pump laser 116. The compensation of the optical power may be effected by measuring the optical power of the optical transmission signal S_{1,opf} at the output port of the optical amplifier 100, e.g., by using the signal of the sensor device 102 of the second stage 202. For example, the control device 203 may control one of the pump lasers 116 to operate at a changed injection current as explained below, i.e., at a changed operating point, resulting in a changed gain of the respective stage 201, 202. In order to compensate this gain change of the respective stage 201, 202 of the optical amplifier 100, the control device 203 monitors the signal of the sensor device 102 of the second stage 202 and controls the respective other pump laser to operate at an also changed operating point which is chosen in such a way that the signal of the sensor device 102 remains at a constant value. In this way, the optical power of the optical transmission signal S_{1,opt} at the amplifier output port is kept essentially constant.

In this way, either one or, preferably, both of the pump lasers can be monitored with respect to their stage of aging as the values defining the operating points during normal operation as well as the values defining the changed operating points can be determined.

Compensating the change of the operating point of a pump laser in an optical amplifier that comprises two or more pump lasers (either in the same stage or in different stages) leads to the advantage that the gain of the amplifier can be kept constant so that the optical power of the optical transmission signal at the amplifier output port can be kept constant. In this way, a deterioration of the transmission quality can be minimized.

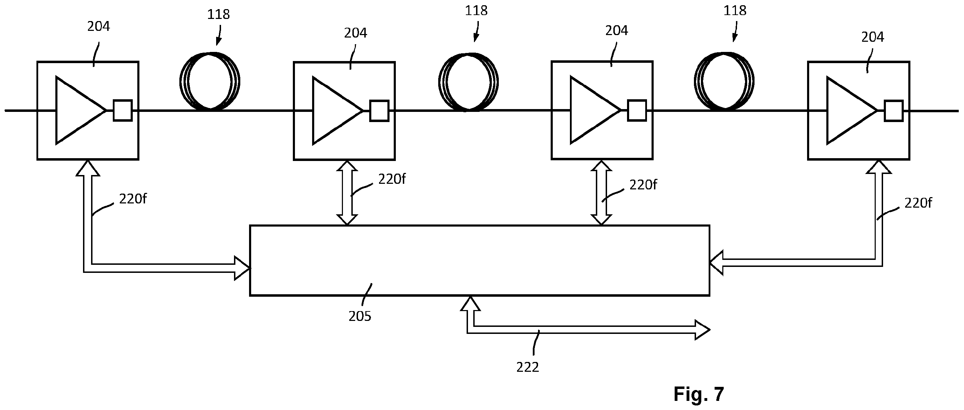

However, as will be explained with reference to Fig. 7, it is generally also possible to compensate a change of the operating point of the pump laser in one optical amplifier by correspondingly changing the operating point of a pump laser in a further optical amplifier included in the same optical transmission link irrespective of the number of pump lasers included in the respective optical amplifiers. It is also possible to compensate the change in the output power of the pump laser to be monitored by controlling two or more pump lasers in such a way that their operating points are changed in an appropriate manner. Of course, as the method shall be carried out during the operation of the optical transmission link, the overall goal is to maintain a sufficient transmission quality of the optical transmission link as explained above. In order to maintain the transmission quality, it would generally be necessary to maintain a sufficiently high optical power of the optical transmission signal at least at the respective receiving end of the optical transmission link. However, it is desirable to maintain a sufficiently high optical power of the optical transmission signal at any location within the optical transmission link, especially at the output ports of all optical amplifiers provided within the optical transmission link. Of course, in order to carry out the above-explained compensation of the shift of the operating point of a selected pump laser to be monitored, the optical power of the optical transmission signal must be measured at a location downstream of any of the pump lasers involved in this monitoring process.

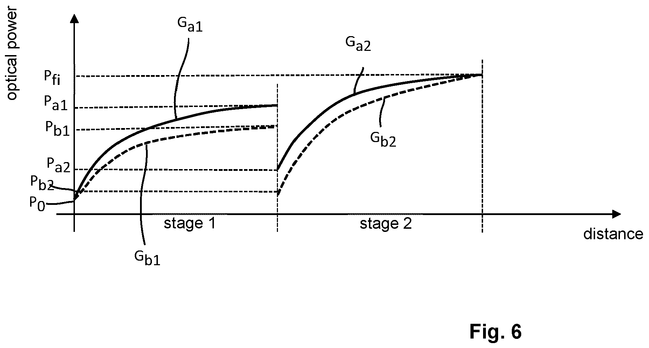

Fig. 6 shows a diagram illustrating the course of the optical power of the optical transmission signal S_{1,opt} along the optical path within the two-stage optical amplifier 100 (which is mainly given by the respective EDF) in Fig. 4 or 5, respectively, wherein the above-explained compensation is carried out during the process of monitoring the stage of aging of one or both pump lasers 116. In the example shown in Fig. 6, the pump power of the pump laser 116 in the first stage 201 is reduced whereas the pump power of the pump laser in the second stage 202 is increased in such a way that the optical power of the optical transmission signal S_{1,opt} at the output port of the optical amplifier 100 and thus its total gain is kept constant. In the diagram shown in Fig. 6, as an example, two operating states of the optical amplifier 100 are illustrated by a first curve Gₐ and the second curve G_{b}, wherein the first curve Gₐ comprises a first and a second section Gₐ₁, Gₐ₂ and the second curve G_{b} comprises a first and a second section G_{b1}, G_{b2}. Each of these first sections Gₐ₁, G_{b1} illustrates the course of the optical power of the optical transmission signal in the first stage 201 and each of these second sections Gₐ₂, G_{b2} illustrates the course of the optical power of the optical transmission signal in the second stage 202. The first curve Gₐ starts at optical power P₀ and reaches optical power Pₐ₁ after the first stage. The course of the power according to curve Gₐ then abruptly decreases to a value Pₐ₂ due to a respective attenuation introduced by the VOA 106. After this abrupt decrease, the optical power of the optical transmission signal S_{1,opt} gradually increases in the following second stage until it reaches a maximum value P_{fi} at the end of the second stage. The second curve G_{b} that describes the further shifted operating point also starts at the value P₀ and reaches an optical power value P_{b1} after the first stage. The optical power is then attenuated by the VOA 106 by the same amount to the optical power value P_{b2} and, in the following, gradually increases until it again reaches the optical power value P_{fi} after the second stage.

As shown in connection with this simple example, it is possible to essentially maintain the function of an optical transmission link comprising one or more optical amplifiers (which as a whole comprise two or more pump lasers) while varying the optical pump power, i.e. the operating point, of a first pump laser as this variation is compensated by correspondingly changing the optical pump power, i.e. the operating point, of a second pump laser. If the pump lasers are included in the same optical amplifier, the optical power of the optical transmission signal at the output port thereof can be maintained. Of course, the optical power of the two pump lasers can be varied in a predetermined range as long as the (total) gain of the optical amplifier can be maintained (and the noise properties of the amplifier are not deteriorated beyond a predetermined threshold value of a parameter that describes the noise properties, e.g. the noise figure). In this way, the transmission quality of the respective optical transmission link can be maintained.

Fig. 7 shows a part of an optical transmission link comprising four single-stage optical amplifiers 204, wherein each of the single-stage optical amplifiers may have the same structure and functionality as one of the stages of the two-stage optical amplifier shown in Fig. 4. The input ports and output ports of neighboring optical amplifiers 204 are connected by an optical transmission path 118, which is usually realized by an optical fiber. Each of the optical amplifiers 204 is configured to control the operating point of at least one pump laser included in the optical amplifier 204 corresponding to a control information provided by a management system 205. The management system 205 realizes a (higher-order) control device, which is capable of carrying out the monitoring method explained above. For this purpose, each of the optical amplifiers 204 and the management system 205 are in bidirectional communication (indicated by the double arrows 220). This communication may be realized by means of a management channel as explained above. Each of the optical amplifiers 204 is further capable of transmitting information concerning the current operating point, i.e., the values of the respective optical pump power and the injection current, to the management system 205, which is generally configured to carry out any step of the method of monitoring one or more pump lasers of one or more optical amplifiers. The optical amplifiers 204 may additionally be configured to transmit the optical power of the optical transmission signal S_{1,opf} that is present at the respective output port of the optical amplifier 204 to the management system 205.

The management system 205 may be configured to carry out the method described in connection with the embodiments shown in Figs. 4 and 5. In this case, two neighboring single-stage optical amplifiers 204 may be regarded as the first and second stage in these embodiments. However, also two arbitrary single-stage optical amplifiers, even if not in a neighboring relationship, may be deemed to be treated as two-stage optical amplifier.

The compensation of a pump power caused by the shift of the operating point of a respective pump laser through an "opposite" shift of the operating point of a further pump laser may be carried out analogously as previously described in connection with Fig. 6, wherein the first stage in Fig. 6 corresponds to a first single-stage optical amplifier 204 and the second stage in Fig. 6 corresponds to a second single-stage optical amplifier 204, preferably (but not necessarily) successive single-stage optical amplifier 204. The management system 205 may use the optical power of the optical transmission signal at the output port of the most downstream optical amplifier 204 that is involved in the process of monitoring the status of aging in order to control the desired shift of the operating point of the pump laser which is necessary to compensate the shift of the operating point of another pump laser.

As mentioned above, the method of monitoring the state of aging of at least one pump laser and a respective compensation may be carried out in a more complex way. Especially, the one or more first pump lasers may be shifted in their operating points according to predetermined specifications. In order to compensate these shifts, one or more second pump lasers may be shifted in the corresponding opposite direction along the LI curve. At least for all of the first pump lasers the method of monitoring the stage of aging is carried out by determining the values of the shifted operating points and approximating the actual current LI curve by carrying out a regression analysis. Of course, also for the second pump lasers that are involved in compensating the shift of the first pump lasers, the method of monitoring the stage of aging may be carried out.

The specifications for the shift of the operating points of the at least one first pump laser are communicated, in case of a structure according to Fig. 7, from the management system 205 to the respective optical amplifiers 204. In case of a structure similar to Fig. 7, wherein instead of single-stage optical amplifiers two-stage optical amplifiers according to Fig. 5 are provided, the management system 205 may communicate with the control device 203 that is included in each of the two-stage optical amplifiers in order to transmit these specifications to the respective pump lasers. In this case, the tasks to be carried out in order to monitor for the stage of aging of one or more pump lasers may be distributed between the control devices 203 and the management system 205. Generally, such a combination of control devices 203 and a higher-order control device for management system 205 may also be referred to as control device.

In general, such a generalized control device and its functionality may be distributed and realized in two or more devices as already indicated above.

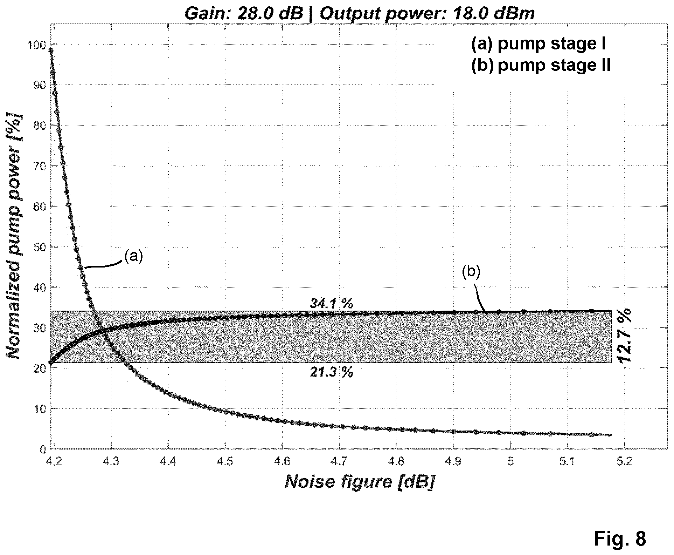

Fig. 8 shows two curves (a) and (b) which represent the normalized pump power in percent versus the noise figure in dB of two stages of either a two-stage optical amplifier or two single optical amplifiers, wherein these two stages are referred to as pump stage I and pump stage II. The specification for this case is a total amplifier gain of 28.0 dB and an output power of 18.0 dBm for the amplified signal. The two curves (a) and (b) are linked in that curve (a) shows the pump power of the first stage and curve (b) shows the corresponding necessary pump power of second stage in order to begin and finish in the same points as described in Fig. 6.

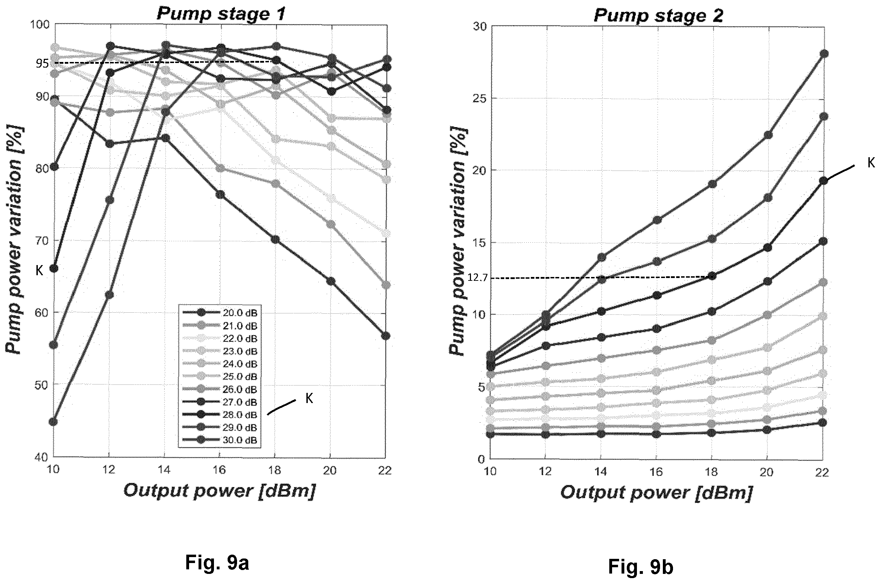

Figs. 9a and 9b show a simulation of pump power variations for an allowable noise figure degradation of 1dB versus output power for various gain settings. They essentially show how much the first and second pump laser vary their pump power for given specifications of gain and output power. In Fig. 8, the gain is set to 28.0 dB and the output power to 18.0 dBm. The normalized power value of curve (a), which corresponds to pump stage 1 and therefore to the first pump laser, varies from about 98% to about 3%, which corresponds to a variation of about 95%. The corresponding curve in Fig. 9a with a gain of 28.0 dB is labeled with a K. Following the curve to an output power of 18.0 dBm. a pump power variation of 95% is obtained, which is what is also apparent from Fig. 8. Following the curve K in Fig. 9b to 18 dBm output power, a corresponding pump power variation of 12.7% is found. In Fig. 8, the same variation (highlighted by the gray area) in normalized pump power can be seen in curve (b). That means, in case of a 28dB gain, it would be possible to vary the pump power of the first pump laser by up to 95% and the pump power of the second pump laser up to 12.7% and still maneuver within the predetermined possible paths which all begin at the same point and end at the same point as described in Fig. 6. Analogously, the other corresponding curves in Figs. 9a and 9b show the connection between the variations in pump power of the lasers of the first stage and the lasers of the second stage for different gains.

### List of Reference Signs

- 100: two-stage optical amplifier
- 101: first optical sensor device
- 102: second optical sensor device
- 106: variable optical attenuator
- 108: erbium-doped fiber
- 110: optical isolator
- 112: first tap coupler
- 113: second tap coupler
- 114: first wavelength selective coupler (WSC)
- 115: second wavelength selective coupler (WSC)
- 116: pump laser
- 118: optical transmission path
- 201: first stage of optical amplifier 100
- 202: second stage of optical amplifier 100
- 203: control device
- 204: one-stage optical amplifier
- 205: management system
- 210: bidirectional communication path
- 214: bidirectional communication path
- 220: bidirectional communication path
- 222: bidirectional communication path
- 300: target value of output power
- Gₐ: first curve describing power distribution along the axis of an erbiumdoped fiber of an amplifier
- G_{b}: second curve describing power distribution along the axis of an erbiumdoped fiber of an amplifier
- Gₐ₁: first section of curve Gₐ
- Gₐ₂: second section of curve Gₐ
- G_{b1}: first section of curve G_{b}
- G_{b2}: second section of curve G_{b}
- Iₐₗ: maximum value of the injection current
- I_{op,BOL}: value of injection current at an operating point on LI curve at BOL
- I_{op,ag}: value of injection current at an operating point on LI curve after aging
- I_{BOL,tgt}: value of injection current at BOL at target optical pump power

- P_{tgt}: specified target value of optical pump power
- P_{op,BOL}: value of optical pump power at an operating point on LI curve
- P₀: optical power at input of an optical amplifier or the first amplifer stage, respectively
- P_{fi}: optical power at output of an optical amplifier or the second amplifer stage, respectively
- Pₐ₁, P_{b1}: power levels at the output of a first amplifier stage
- Pₐ₂, P_{b2}: power levels at the input of a second amplifier stage

- OP_{BOL}: operating point on LI curve at BOL
- OP_{ag}: operating point on LI curve after aging
- OP_{BOL,tgt}: operating point on LI curve at BOL at target optical pump power
- OP_{ag,tgt}: operating point on LI curve after aging at target optical pump power
- OPᵢ: operating point on LI curve (current aging status); -2 ≤ i ≤ 3

- S_{1,opt}: optical transmission signal
- S_{ic}: interaction current control signal
- Sₚₚ: pump power signal
- S_{wp}: signal generated by an optical sensor device

## Claims

1. Method for monitoring a pump laser (116) of at least one optical amplifier (100, 204) in an optical transmission link in operation,
(a) wherein the optical output power of the pump laser (116) to be monitored depends on an injection current and wherein the pump laser (116) to be monitored is operated at an operating point defined by a given value of the injection current and a corresponding value of the optical output power,
the method comprising the steps of:
(b) shifting the operating point of the pump laser (116) to be monitored to at least one further operating point (shifted operating point), wherein the shift is effected in such a way that the gain of the respective optical amplifier (100, 204) essentially reaches its steady state,
(c) determining information on the at least one shifted operating point, and
(d) using the information on the operating point and the at least one shifted operating point to determine information on the stage of aging of the pump laser (116) to be monitored.

2. The method of claim 1, wherein the at least one shifted operating point is reached
(a) by controlling the injection current to a different, shifted value and measuring the resulting optical pump power in order to obtain the information on the shifted operating point, or
(b) by controlling the optical pump power to a different, shifted value and measuring the resulting injection current in order to obtain the information on the shifted operating point, or
(c) by controlling the optical power of an optical transmission signal at an output port of the optical amplifier (100, 204) comprising the pump laser (116) to be monitored to a different, shifted value and measuring the resulting optical pump power and the resulting injection current to obtain the information on the shifted operating point.

3. The method of claim 1 or 2, wherein the at least one shifted operating point is determined in such a way that one or more parameters characterizing the transmission quality of the optical transmission link are not changed by more than a predetermined amount or do not exceed a predetermined threshold or do not fall below a predetermined threshold.

4. The method according to any of the preceding claims, wherein the change in optical output power of a first pump laser (116) between the operating point and the at least one further operating point is compensated by a change of an injection current of at least one second pump laser (116).

5. The method of claim 4, wherein the second pump laser (116) is a component of either the same optical amplifier (100, 204) as the first pump laser (116) or of a further optical amplifier (100, 204).

6. The method according to one of claims 4 or 5, wherein the compensation of the optical power is effected by measuring the optical power of an optical transmission signal at a predetermined position within the optical transmission link, which is located downstream of the at least one second pump laser (116), preferably in the region of an output port of a selected one of the one or more optical amplifiers (100, 204), and controlling the injection current of the at least one second pump laser in such a way that the optical power of the optical transmission signal remains essentially constant.

7. The method according to any of the preceding claims, wherein the information on the stage of aging of the pump laser (116) to be monitored comprises a maximum value of the optical output power at a predetermined maximum value of the laser injection current of the amplifier (100, 204) in its current stage of aging or an information dependent on this maximum value of the optical output power.

8. The method according to any of the preceding claims, wherein the information on the stage of aging is obtained at predetermined points in time or at given time intervals and wherein, from this information, the maximum period of time is determined for which the pump laser (116) fulfills a predetermined specification requirement, for example a predetermined minimum value of the optical pump power that is reached at a maximum specified value of the injection current.

9. The method according to any of the preceding claims, wherein the optical transmission link is an optical wavelength division multiplex (WDM) transmission link operated with a number of optical channels smaller than a given maximum number of channels and wherein the information on the stage of aging of the pump laser (116) to be monitored is a number of channels or capacity increase by which the optical WDM transmission link can be expanded without exceeding a given maximum value of the injection current and/or whether it is still possible to expand the optical WDM transmission link to the given maximum number of channels.

10. The method according to any of the preceding claims, wherein the information on the stage of aging of the pump laser (116) to be monitored is determined by applying a mathematical regression method, especially linear extrapolation, using the values of the injection current and the respective values of the optical output power defining the operating point and the at least one shifted operating point.

11. A control device (203) for controlling and monitoring a pump laser (116) of at least one optical amplifier (100, 204) in an optical transmission link, the control device (203) being configured
(a) to receive information on an operating point of the pump laser (116) to be monitored, wherein the operating point is defined by a value of the injection current supplied to the at least one pump laser (116) and a corresponding value of the optical output power created by the at least one pump laser (116), and
(b) to output control information to the at least one optical amplifier (100, 204) at least comprising information defining the operating point,
**characterized in**
(c) that the control device (203) is further configured
i. to output information to the at least one optical amplifier (100, 204) that is adapted to create at least one shift of the operating point in order to operate the pump laser (116) to be monitored, for a predetermined time, at at least one shifted operating point,
ii. to receive information created by the at least one optical amplifier (100, 204) defining the shifted operating points, and
iii. to use the information on the operating point and the at least one shifted operating point using the values of the operating point and the at least one further operating point to determine information on the stage of aging of the pump laser (116) to be monitored.

12. The control device (203) according to claim 11, **characterized in that** the control device (203) is configured to carry out the method according to any of claims 2 to 10.

13. An optical amplifier (100, 204) comprising a control device configured for monitoring a pump laser of at least one optical amplifier in an optical transmission link in operation according to one of claims 11 or 12.

14. An optical transmission link comprising at least one optical amplifier (100, 204) and a control device configured for monitoring a pump laser (116) of at least one optical amplifier (100, 204) in an optical transmission link in operation according to one of claims 11 or 12.
